(19) Europäisches Patentamt
European Patent Office
Office européen des brevets

(11) **EP 2 802 886 B1**

(12) **FASCICULE DE BREVET EUROPEEN**

(45) Date de publication et mention
de la délivrance du brevet:
**22.06.2016 Bulletin 2016/25**

(21) Numéro de dépôt: **13700491.7**

(22) Date de dépôt: **07.01.2013**

(51) Int Cl.:
**G01R 15/20** *(2006.01)*    **G01R 33/09** *(2006.01)*
**G01R 33/00** *(2006.01)*

(86) Numéro de dépôt international:
**PCT/EP2013/050155**

(87) Numéro de publication internationale:
**WO 2013/104584 (18.07.2013 Gazette 2013/29)**

(54) **CAPTEUR DE CHAMP MAGNETIQUE**

MAGNETFELDSENSOR

MAGNETIC FIELD SENSOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.01.2012 FR 1250313**

(43) Date de publication de la demande:
**19.11.2014 Bulletin 2014/47**

(73) Titulaires:
• **Commissariat à l'Énergie Atomique et aux Énergies Alternatives**
**75015 Paris (FR)**
• **Renault S.A.S.**
**92100 Boulogne-Billancourt (FR)**

(72) Inventeurs:
• **DELAET, Bertrand**
**F-38190 Bernin (FR)**
• **BACQUET, Sylvain**
**F-38470 Chasselay (FR)**

(74) Mandataire: **GIE Innovation Competence Group**
**310, avenue Berthelot**
**69372 Lyon Cedex 08 (FR)**

(56) Documents cités:
**FR-A1- 2 902 890    US-A1- 2006 291 106**

**Description**

L'invention concerne un capteur de champ magnétique et un procédé de mesure d'un champ magnétique. L'invention concerne également un support d'enregistrement pour la mise en oeuvre de ce procédé et un capteur de courant incorporant le capteur de champ magnétique.

Des capteurs de courant connus comportent :

- un conducteur électrique s'étendant le long d'une direction X et dans laquelle circule le courant à mesurer,
- un capteur de champ magnétique fixé sans aucun degré de liberté à ce conducteur électrique pour mesurer le champ magnétique généré par le courant à mesurer lorsqu'il circule dans ce conducteur électrique, et
- un calculateur programmé pour établir la mesure de l'intensité du courant à mesurer à partir de la mesure de l'intensité du champ magnétique mesurée par le capteur de champ magnétique.

Le capteur de champ magnétique utilisé dans ce capteur de courant comporte N transducteurs magnétorésistifs $TM_i$, la résistance de chaque transducteur $TM_i$ variant linéairement à $\pm x_i\%$ près en fonction de l'intensité du champ magnétique à mesurer dans une plage maximale $[a_i, b_i]$ d'intensité du champ magnétique à mesurer et non linéairement en dehors de cette plage, N étant un nombre entier supérieur ou égal à deux et l'indice i étant un identifiant du transducteur $TM_i$.

Un tel capteur de courant est par exemple divulgué dans la demande de brevet US2011/0227560 ou dans la demande WO2007148028.

Dans le capteur de courant de US2011/0227560, une ligne de compensation est mise en oeuvre pour générer un champ magnétique $H_d$ de direction opposée à celle du champ magnétique à mesurer $H_m$. Plus précisément, l'intensité du champ $H_d$ est asservie sur celle du champ magnétique $H_m$ pour maintenir proche de zéro le champ $H_r$ résultant de la combinaison de ces deux champs $H_d$ et $H_m$. C'est ce champ $H_r$ qui est mesuré par le transducteur magnétorésistif. Puisque le champ $H_r$ est maintenu proche de zéro, le transducteur magnétorésistif travaille dans la plage où il est le plus linéaire, ce qui accroît sa linéarité.

La présence d'un tel champ $H_d$ permet d'accroître la gamme de mesures du transducteur magnétorésistif. Par « gamme de mesures », on désigne ici la plage maximale sur laquelle la réponse du transducteur magnétorésistif varie linéairement à plus ou moins x% près en fonction de l'intensité du champ $H_m$ à mesurer, où x est une constante prédéterminée.

La linéarité à $\pm x\%$ près sur une plage [a, b] est définie comme suit : quelle que soit la valeur de l'intensité du champ $H_m$ à mesurer appartenant à la plage [a ; b], la valeur absolue d'un ratio $\beta$, exprimé en %, est inférieure à la constante x, où le ratio $\beta$ est défini par la relation suivante : $\beta = (R_m(H_m) - D(H_m))/D(H_m)$, où :

- $R_m(H_m)$ est la valeur du signal généré par le transducteur magnétorésistif lorsqu'il est placé dans le champ $H_m$,
- D est la droite de régression minimisant les écarts, selon la méthode des moindres carrés, entre cette droite et les différentes valeurs $R_m(H_m)$ mesurées sur toute l'étendue de la plage [a ; b],
- $D(H_m)$ est la valeur de la droite de régression pour le champ $H_m$.

Dans la suite de cette description, la plage [a ; b] est la plage maximale, c'est-à-dire la plus grande, sur laquelle la linéarité du transducteur magnétorésistif est inférieure à x %. Ainsi, fixer la valeur de x permet de fixer également la valeur des bornes de la plage [a ; b]. Typiquement, la plage [a ; b] pour une valeur x donnée est mesurée expérimentalement.

Dans ces capteurs connus, la consommation d'énergie pour générer le champ $H_d$ est importante.

Pour augmenter la gamme de mesures d'un transducteur magnétorésistif, il a déjà aussi été proposé par ailleurs de générer un champ magnétique constant parallèlement à la direction de plus facile aimantation de la couche libre des barreaux magnétorésistifs formant ce transducteur magnétorésistif. Typiquement, cette direction est perpendiculaire à celle du champ $H_m$ à mesurer. La présence de ce champ magnétique constant permet effectivement d'accroître la gamme de mesures du transducteur magnétorésistif mais au détriment de la sensibilité de ce transducteur.

De l'état de la technique est également connu de US2006/291106A1.

L'invention vise donc à accroître la gamme de mesures d'un transducteur magnétorésistif en diminuant sa consommation d'énergie et sans pour autant diminuer sa sensibilité. Elle a donc pour objet un capteur de champ magnétique conforme à la revendication 1.

Le capteur ci-dessus présente N plages $[a_i + l_i, b_i + l_i]$ différentes sur lesquelles sa mesure varie linéairement au lieu d'une seule. De plus, sur chaque plage, sa sensibilité est la même que celle obtenue en absence du champ magnétique $CM_i$. Ainsi, la gamme de mesures est accrue sans pour autant diminuer sa sensibilité. De plus, l'utilisation d'aimants permanents pour générer les champs magnétiques $CM_i$ limite la consommation d'énergie du capteur.

Les modes de réalisation de ce capteur peuvent comporter une ou plusieurs des caractéristiques des revendications dépendantes.

Ces modes de réalisation du capteur de champ magnétique présentent en outre les avantages suivants :

- choisir les champs magnétiques $CM_i$ telles que $a_i + l_{i+1} \leq b_i + l_i$, permet d'obtenir une plage continue $[a_1 + l_1 ; b_N + l_N]$ beaucoup plus étendue que chaque

plage [$a_i$ ; $b_i$] sur laquelle la résistance du transducteur magnétorésistif $TM_i$ varie linéairement à ±$x_i$% près.

L'invention a également pour objet un capteur de courant comportant le capteur de champ magnétique ci-dessus.

L'invention a également pour objet un procédé de mesure d'un champ magnétique conforme à la revendication 6.

Les modes de réalisation de ce procédé de mesure peuvent comporter une ou plusieurs des caractéristiques des revendications dépendantes de procédé.

Enfin, l'invention a également pour objet un support d'enregistrement d'informations contenant des instructions pour la mise en oeuvre du procédé de mesure ci-dessus, lorsque ces instructions sont exécutées par un calculateur électronique.

L'invention sera mieux comprise à la lecture de la description qui va suivre, donnée uniquement à titre d'exemple non limitatif et faite en se référant aux dessins sur lesquels :

- la figure 1 est une illustration schématique d'un capteur de courant utilisant des transducteurs magnétorésistifs,
- la figure 2 est une illustration schématique d'un des transducteurs magnétorésistifs du capteur de la figure 1 ;
- la figure 3 est une illustration schématique et en coupe verticale d'un barreau magnétique mis en oeuvre dans le transducteur magnétorésistif de la figure 2 ;
- la figure 4 est un graphe illustrant la réponse du barreau magnétique de la figure 1 à un champ magnétique ;
- la figure 5 est un organigramme d'un procédé de mesure d'un courant à l'aide du capteur de la figure 1 ; et
- la figure 6 est un organigramme d'un autre procédé de mesure du courant à l'aide du capteur de la figure 1.

Dans ces figures, les mêmes références sont utilisées pour désigner les mêmes éléments.

Dans la suite de cette description, les caractéristiques et fonctions bien connues de l'homme du métier ne sont pas décrites en détail.

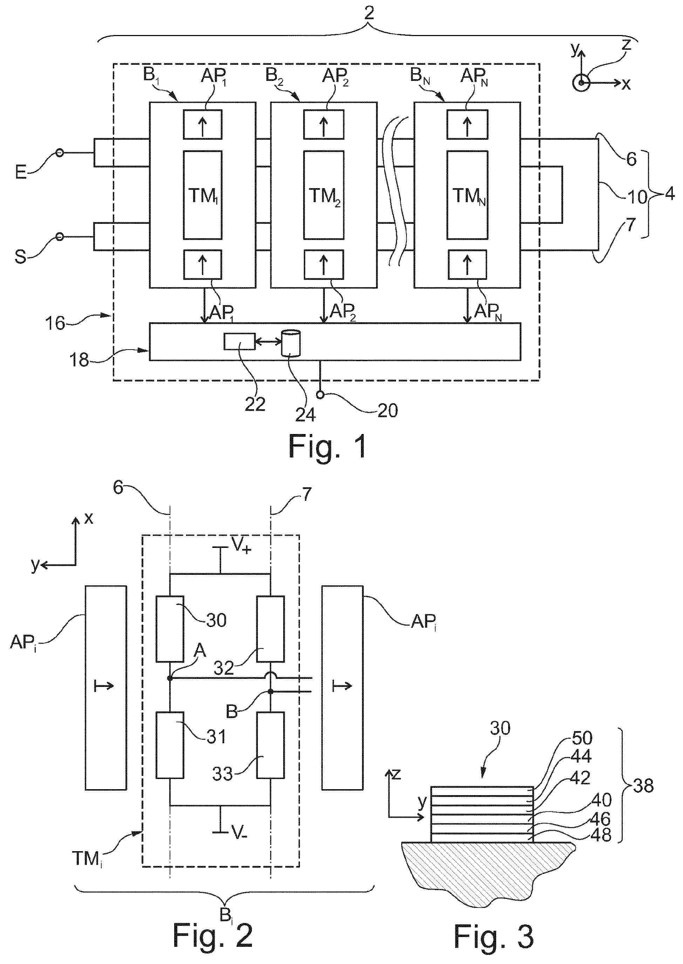

La figure 1 représente un capteur 2 de courant. Ce capteur 2 comporte un conducteur électrique 4. Le conducteur 4 comporte ici deux brins 6, 7 rectilignes et parallèles à une direction horizontale X d'un repère orthogonal X, Y, Z. Dans le repère X, Y, Z, la direction Y est également horizontale et la direction Z est verticale.

Ces brins 6, 7 sont électriquement raccordés entre eux par un brin supplémentaire 10 de sorte que le courant à mesurer circule dans un sens dans le brin 6 et dans le sens opposé dans le brin 7. Ici, ces brins 6, 7 et 10 forment un « U ».

Les brins 6, 7 sont également raccordés, respectivement, à des bornes E et S d'entrée et de sortie du courant à mesurer.

Un support électriquement isolant repose, sans aucun degré de liberté, sur les brins 6 et 7 du conducteur 4. Ce support n'a pas été représenté pour simplifier la figure 1. Par la suite, on considère qu'un matériau est isolant si sa résistivité est supérieure à 1 $\Omega$.m et, de préférence, supérieure à $10^4$ $\Omega$.m à 25°C.

Le capteur 2 comporte également un capteur 16 de champ magnétique fixé sans aucun degré de liberté sur ce support. Ce capteur 16 mesure un champ magnétique $H_m$ généré par un courant $I_m$ circulant dans le conducteur 4. Le champ $H_m$ est perpendiculaire à la direction X.

Ce capteur 16 comporte plusieurs blocs de mesures $B_1$, ..., $B_i$.... $B_N$, où N est un entier supérieur ou égal à deux et, de préférence, supérieur ou égal à quatre, cinq ou dix. L'indice i identifie le bloc de mesures concerné. L'indice i est compris entre un et N.

Pour simplifier la figure 1, seuls trois blocs $B_1$, $B_2$, et $B_N$ sont représentés. Sur cette figure, les traits ondulés verticaux indiquent que des blocs $B_i$ n'ont pas été représentés.

Le bloc $B_i$ mesure le champ magnétique $H_m$. A cet effet, chaque bloc $B_i$ comprend un transducteur magnétorésistif $TM_i$ qui sera décrit plus loin en référence à la figure 2.

Chaque bloc $B_i$ comprend également des aimants permanents $AP_i$ pour créer un champ magnétique $CM_i$ parallèle à la direction Y dans le transducteur $TM_i$. Ici, la direction Y est parallèle à la direction de mesure du champ $H_m$. Par exemple, chaque bloc $B_i$ comprend deux aimants permanents $AP_i$ disposés de part et d'autre du transducteur magnétorésistif $TM_i$. Sur la figure 1, la direction d'aimantation de ces aimants permanents est représentée par une flèche. Ainsi chaque bloc de mesure diffère des autres blocs de mesure par le champ magnétique $CM_j$ et aussi par son transducteur magnétorésistif $TM_i$.

A l'exception des aimants dont ils sont équipés, tous les blocs $B_i$ sont ici identiques les uns aux autres. Ainsi, seul le bloc $B_i$ est décrit plus en détail en référence à la figure 2.

Le capteur 16 comprend également une unité électronique 18 de traitement. Cette unité 18 est apte à établir la mesure de l'intensité du champ $H_m$ le long de la direction de mesure Y à partir des mesures des différents blocs $B_i$. Cette unité 18 est également apte à établir l'intensité du courant $I_m$ à partir de l'intensité mesurée du champ $H_m$. L'unité 18 restitue l'intensité établie du courant $I_m$ sur une sortie 20.

L'unité 18 est raccordée à chaque bloc $B_i$ pour acquérir la mesure $H_{mi}$ réalisée par ce bloc du champ magnétique $H_m$.

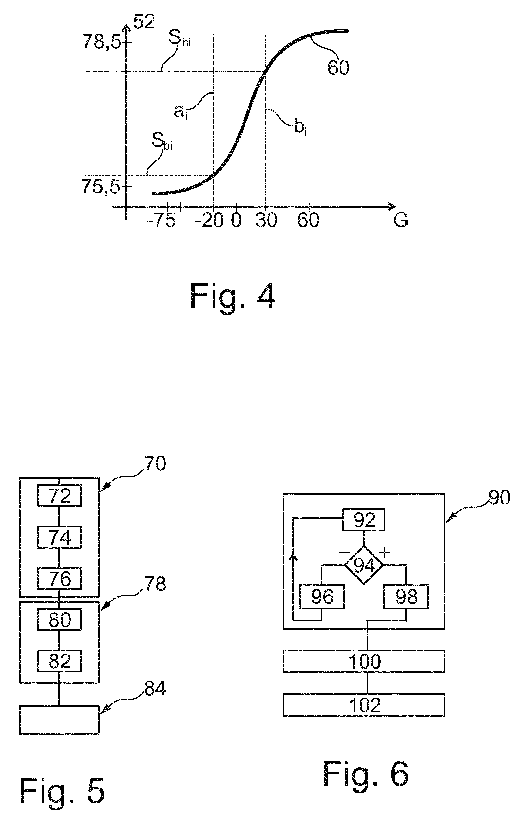

Par exemple, l'unité 18 est réalisée à partir d'un calculateur électronique 22 programmable apte à exécuter des instructions enregistrées sur un support d'enregistrement d'informations. A cet effet, l'unité 18 comprend une mémoire 24 raccordée au calculateur 22. Cette mémoire 24 stocke les instructions nécessaires pour exécuter le procédé de la figure 5 ou 6.

Le bloc $B_i$ comporte quatre barreaux magnétorésistifs 30 à 33 (Figure 2) électriquement raccordés entre eux pour former un pont de Wheatstone. Un barreau magnétorésistif est un composant dont la résistivité varie en fonction du champ magnétique dans lequel il est placé. Les barreaux magnétiques dont il s'agit ici sont soit des vannes de spin soit des jonctions tunnel magnétique.

Ce pont de Wheatstone comprend une première et une seconde branches électriquement raccordées en parallèle entre des potentiels de référence V+ et V-. Le potentiel V- est par exemple la masse ou la terre. La première branche comprend successivement, en allant du potentiel V+ vers le potentiel V-, les barreaux magnétorésistifs 30 et 31 raccordés en série par l'intermédiaire d'un point milieu A. La seconde branche comprend successivement, en allant du potentiel V+ vers le potentiel V-, les barreaux 32 et 33 raccordés en série par l'intermédiaire d'un point milieu B.

Les potentiels $V_A$ et $V_B$ au niveau des points milieux A et B sont donnés par les relations suivantes :

$$V_A = (V_+ - V_-)R_2/(R_1+R_2)$$

$$V_B = (V_+ - V_-)R_4/(R_3+R_4)$$

ou $R_1$, $R_2$, $R_3$ et $R_4$ désignent les résistances, respectivement, des barreaux 30 à 33.

Ici, chaque barreau 30 à 33 a essentiellement une forme de parallélépipède rectangle dont au moins deux grandes faces s'étendent horizontalement. La direction dans laquelle s'étend principalement le barreau est appelée direction longitudinale. Ici, cette direction est horizontale et parallèle à la direction X. La direction transversale est parallèle à la direction Y.

Dans le cas où les barreaux sont des vannes de spin, de préférence, chaque barreau présente un rapport de forme important, c'est-à-dire un rapport de forme supérieur à vingt et, de préférence, supérieur à quarante ou cent. Ce rapport de forme est défini par le rapport de forme entre la longueur L du barreau sur sa largeur transversale W.

Par exemple, la longueur L est supérieure à 50 ou 100 $\mu$m et, de préférence, inférieure à 1 mm. La largeur transversale W est typiquement supérieure à 0,3 $\mu$m ou 1 $\mu$m et, de préférence, inférieure à 15 $\mu$m ou 30 $\mu$m. Le rapport de forme est beaucoup plus faible lorsque le barreau est une jonction tunnel magnétique. Dans ce dernier cas, le rapport de forme peut être inférieur à cinq ou dix.

Ici, les barreaux 30 et 31 sont disposés au-dessus du brin 6 de manière à être au moins deux ou trois fois plus proches de ce brin 6 que du brin 7. Ainsi, les barreaux 30 et 31 sont essentiellement sensibles au champ magnétique $H_m$ créé par le courant qui circule dans le brin 6. Sur la figure 2, les brins 6 et 7 sont représentés par des axes portant les mêmes références numériques.

De façon similaire, les barreaux 32 et 33 sont disposés au-dessus du brin 7 de manière à être deux ou trois fois plus proches de ce brin 7 que du brin 6. Ainsi, les barreaux 32 et 33 sont essentiellement sensibles au champ magnétique $H_m$ créé par le courant qui circule dans le brin 7.

Les barreaux 31 et 32 sont agencés de sorte que leurs résistances respectives varient dans le même sens en réponse à la même variation du courant $I_m$ à mesurer. Ici, les barreaux 31 et 32 sont identiques.

Dans ce mode de réalisation, les barreaux 30 et 33 sont également identiques aux barreaux 31 et 32. Toutefois, le bloc $B_i$ est agencé de manière à ce que leur résistance ne varie pas en réponse à une variation de l'intensité du courant $I_m$. Par exemple, le bloc $B_i$ comprend un écran magnétique interposé entre les barreaux 30 et 33 et le conducteur 4.

L'unité 18 de traitement reçoit la différence entre les potentiels VA et $V_B$ pour établir l'intensité du courant $I_m$ circulant dans le conducteur 4.

Les structures des différents barreaux magnétorésistifs sont identiques et seule la structure du barreau 30 est décrite plus en détail en références à la figure 3.

Le barreau 30 comporte un empilement 38, immédiatement consécutif, d'une couche de référence 40, d'un espaceur 42 et d'une couche libre 44 dans la direction verticale. Un tel empilement pour obtenir une magnétorésistance géante ou GMR (Geant Magneto-Resistance) est conventionnel. Les GMR sont également connues sous le terme « vanne de spin ». Cet empilement ne sera donc pas décrit en détail.

La couche 40 de référence a une aimantation de direction fixe et perpendiculaire à la direction X. Par « direction fixe », on désigne ici le fait que la direction d'aimantation de cette couche est beaucoup plus difficile à modifier que la direction d'aimantation de la couche libre.

Par exemple, la couche 40 est une couche ferromagnétique. Elle peut être réalisée en cobalt, en nickel ou en fer ou dans leurs alliages tels que CoFe, NiFe, CoFeB ou autres.

La direction d'aimantation de la couche 40 est fixée à l'aide d'une couche 46 anti-ferromagnétique. La couche 46 sert à piéger la direction d'aimantation de la couche 40. Par exemple, la couche 46 est réalisée dans un alliage de manganèse tel que l'un des alliages suivants IrMn, PtMn, FeMn, NiMn ou autres.

L'espaceur 42 est une couche réalisée en matériau non magnétique. Cet espaceur 42 est suffisamment épais pour découpler magnétiquement les couches 40 et 44. Ici, l'espaceur 42 est une couche en matériau conducteur tel que du cuivre.

La couche libre 44 présente une direction d'aimantation qui peut plus facilement tourner que celle de la couche de référence. La direction de plus facile aimantation de cette couche 44 est ici parallèle à la direction longitudinale du barreau, c'est-à-dire ici la direction X. Par exemple, la couche 44 est une couche réalisée en matériau ferromagnétique ou un empilement de couches ferromagnétiques.

L'empilement 38 comprend à chaque extrémité une électrode conductrice, respectivement, 48 et 50 pour faire circuler le courant qui traverse le barreau magnétorésistif perpendiculairement au plan des couches 40, 42 et 44.

Pour simplifier la figure 3, les rapports d'épaisseurs entre les différentes couches de l'empilement 38 n'ont pas été respectés sur cette figure.

La variation de la résistance du barreau magnétorésistif 30 en fonction de l'intensité d'un champ magnétique à l'intérieur duquel il est placé est représentée sur la figure 4 par une courbe 60. L'axe des abscisses est gradué en Gauss et l'axe des ordonnées représente la résistance du barreau 30 exprimée en Ohm.

Sur cette figure, la courbe 60 varie linéairement à plus ou moins $x_i$% près dans une plage $[a_i ; b_i]$ centrée autour du champ nul. Ici, la valeur $x_i$ est choisie inférieure à 20 % ou 10 % et, de préférence, inférieure à 5 % ou 1 % ou 0,5 %. Par exemple, dans ce mode de réalisation, la valeur $x_i$ est choisie égale à 1% ou 0,25 %. Dans ces conditions, les bornes $a_i$ et $b_i$ sont sensiblement égales, respectivement, à -20G et +30G. Dans ce mode de réalisation, la valeur $x_i$ est la même pour tous les blocs $B_i$.

Sur la plage $[a_i, b_i]$, la résistance du barreau 30 varie linéairement entre un seuil bas $S_{bi}$ et un seuil haut $S_{hi}$. Les valeurs des bornes $a_i$, $b_i$ et des seuils $S_{hi}$ et $S_{bi}$ sont connues. Par exemple, elles sont mesurées expérimentalement. En dehors de la plage $[a_i, b_i]$, la réponse du barreau 30 varie de façon non linéaire. Par « non linéaire », on signifie que si la valeur de la borne $a_i$ était diminuée ou si la valeur de la borne $b_i$ était augmentée, alors la réponse du barreau 30 ne serait plus linéaire à $\pm x_i$ % près sur cette nouvelle plage $[a_i ; b_i]$.

Plus précisément, la courbe 60 augmente de façon non linéaire d'environ -75G à $a_i$ puis de $b_i$ à environ 60G. En dessous de -75G et au-dessus de 60G, le barreau 30 est saturé. Lorsque le barreau 30 est saturé, sa résistance ne varie plus en fonction de l'intensité du champ magnétique $H_m$ à mesurer.

Puisque la réponse du barreau 30 est linéaire dans la plage $[a_i ; b_i]$, la réponse du transducteur magnétorésistif $TM_i$ varie également linéairement à $\pm x_i$% près dans la plage $[a_i ; b_i]$.

La sensibilité du barreau 30 est fonction de la pente de la droite de régression dans la plage $[a_i, b_i]$. Plus précisément, plus la pente est importante, plus la sensibilité du barreau 30 est importante. Or, plus la sensibilité du barreau est importante, plus la sensibilité du transducteur $TM_i$ est également importante.

On notera à ce stade-là que si, comme dans l'état de l'art, un champ magnétique est généré parallèlement à la direction de plus facile aimantation de la couche libre du barreau, alors l'étendue de la plage $[a_i, b_i]$ augmente mais la pente de la droite de régression dans cette plage diminue. Ainsi, comme expliqué précédemment, toute tentative d'augmenter la plage $[a_i ; b_i]$ en appliquant un champ magnétique le long de la direction X réduit la sensibilité du barreau magnétorésistif et donc du transducteur magnétorésistif incorporant ce barreau. A l'inverse, le mode de réalisation décrit ici, permet d'augmenter la plage $[a_i, b_i]$ sans diminuer la sensibilité du capteur.

A cet effet, chaque bloc $B_i$ comporte au moins un aimant, ici les aimants $AP_i$, qui génère un champ magnétique $CM_i$ uniforme dans le bloc $B_i$. On considère que le champ magnétique $CM_i$ est uniforme si l'intensité de ce champ magnétique est la même dans chaque barreau magnétique 30 à 33 à $\pm 20$ % près et, de préférence, à $\pm 10$ ou 5 ou 1% près.

Chaque champ magnétique $CM_i$ est constant et indépendant du champ $H_m$. Autrement dit, l'intensité de champ $CM_i$ ne varie pas systématiquement en réponse à une variation de plusieurs Gauss de l'intensité du champ $H_m$. L'intensité du champ $CM_i$ est notée par la suite $I_i$.

Dans ce mode de réalisation, le champ $CM_i$ est généré par deux aimants $AP_i$ placés respectivement à droite et à gauche du transducteur $TM_i$ dans la direction Y.

Le champ $CM_i$ vient se combiner au champ $H_m$ pour former un champ magnétique résultant $H_{ri}$ dont l'intensité est égale à la différence entre l'intensité du champ $H_m$ et l'intensité $I_i$.

Le transducteur $TM_i$ mesure l'intensité du champ $H_{ri}$ et non pas directement l'intensité du champ $H_m$. Puisque le champ $CM_i$ est constant, la plage, dans laquelle la réponse du transducteur magnétique $TM_i$ est linéaire, est décalée et devient $[a_i + I_i, b_i + I_i]$. Ce décalage ne modifie en rien la sensibilité du transducteur $TM_i$.

Les autres blocs $B_i$ sont identiques à celui décrit ici en détail sauf que leurs aimants permanents $AP_i$ génèrent un champ magnétique $CM_i$ d'intensité $I_i$ différente.

Ici, les différents champs magnétiques $CM_i$ sont choisis de telle manière que toutes les plages $[a_i + I_i, b_i + I_i]$ se chevauchent. Ici, les intensités $I_i$ sont classées par ordre croissant d'indice i de sorte que ce chevauchement se traduit par la relation suivante : $a_{i+1} + I_{i+1} \leq b_i + I_i$. De préférence, les intensités des champs magnétiques $CM_i$ sont choisies de telle sorte que $a_{i+1} + I_{i+1} = b_i + I_i$ à $\pm 5$% ou 15% près. Dans la suite de cette description, l'intensité $I_i$ est négative si la direction d'aimantation de l'aimant permanent est opposée à la direction Y.

Ici, parmi les différents blocs $B_i$, l'un de ces blocs, noté $B_k$, est dépourvu d'aimant permanent de sorte que l'intensité $I_k$ est nulle.

Le chevauchement des différentes plages $[a_i + I_i, b_i + I_i]$ forme une grande plage $[a_1 + I_1 ; b_N + I_N]$ où la réponse du capteur 16 varie linéairement à $\pm x_i$% près

comme expliqué ci-dessous.

La réunion des différents aimants permanents $AP_i$ forme un générateur de champ magnétique apte à générer les N champs magnétiques $CM_i$.

Le fonctionnement du capteur 2 va maintenant être décrit en référence au procédé de la figure 5.

On suppose que le courant $I_m$ circule dans le conducteur 4, ce qui génère le champ $H_m$ dans chacun des blocs $B_i$.

Initialement, lors d'une étape 70, le calculateur 22 sélectionne le bloc $B_i$ pour lequel l'intensité du champ $H_m$ est comprise dans la plage $[a_i + I_i, b_i + I_i]$. Pour cela, lors d'une opération 72, le bloc $B_k$ mesure une intensité du champ $H_m$. L'intensité ainsi mesurée est ensuite acquise par le calculateur 22.

Ensuite, lors d'une opération 74, le calculateur 22 estime l'intensité du champ $H_m$ à l'aide de la mesure acquise à partir du bloc $B_k$. Cette mesure est convertie en une estimation $H_{em}$ de l'intensité du champ magnétique $H_m$ en utilisant une courbe de calibration préenregistrée telle que la courbe 60 de la figure 4. Une telle estimation peut être construite à partir de la courbe 60 tant que les barreaux du bloc $B_k$ ne sont pas saturés. Dans ce cas, l'estimation $H_{em}$ est précise si celle-ci se situe dans la plage $[a_k ; b_k]$. En dehors de cette plage, une estimation moins précise peut être construite en utilisant les zones non linéaires de la courbe 60. Par contre, si les barreaux du bloc $B_k$ sont saturés, alors les étapes 72 et 74 sont réitérées en utilisant un autre bloc $B_i$, où l'indice i est différent de l'indice k. Plus précisément, si les barreaux sont saturés dans leur partie basse, alors l'indice i du bloc utilisé à la place du bloc $B_k$ est choisi égal à la partie entière de k/2. Si le bloc $B_k$ est saturé dans sa partie haute, au-delà du seuil $S_{hi}$, alors la valeur de l'indice i pour le bloc $B_i$ qui sera utilisé à la place du bloc $B_k$ est choisie égale à la partie entière de N - k/2.

A l'issue de l'étape 74, une estimation $H_{em}$ est obtenue. Ensuite, lors d'une opération 76, le calculateur 22 sélectionne le bloc $B_s$ parmi l'ensemble des blocs $B_i$ pour lequel l'intensité estimée $H_{em}$ appartient à la plage $[a_s + I_s; b_s + I_s]$.

Ensuite, lors d'une étape 78, le calculateur 22 établit la mesure de l'intensité du champ $H_m$. Pour cela, lors d'une opération 80, le bloc $B_s$ mesure le champ $H_m$ et la mesure ainsi réalisée est acquise par le calculateur 22. Puis, lors d'une opération 82, le calculateur 22 établit la mesure de l'intensité du champ $H_m$ uniquement à partir de la mesure du bloc $B_s$.

Ainsi, la gamme de mesure du capteur 16 correspond à l'assemblage des différentes plages $[a_i + I_i, b_i + I_i]$ tandis que sa sensibilité reste identique à celle des blocs $B_i$ non saturés. Plus précisément, la gamme de mesures du capteur 2 est alors la plage $[a_1 + I_1 ; b_N + I_N]$ qui est beaucoup plus large que la gamme de mesures d'un seul bloc $B_i$.

Ensuite, lors d'une étape 84, le calculateur 22 établit également la mesure de l'intensité du courant $I_m$ à partir de la mesure de l'intensité du champ $H_m$ établie

lors de l'étape 78.

La figure 6 représente un autre procédé de fonctionnement du capteur 2.

Lors d'une étape 90, le calculateur 22 sélectionne le bloc $B_i$ pour lequel l'intensité du champ $H_m$ est comprise dans la plage $[a_i + I_i, b_i + I_i]$. Pour cela, lors d'une opération 92, chaque bloc $B_i$ mesure l'intensité du champ $H_m$ et le calculateur 22 acquiert chacune de ces mesures. Ainsi, lors de cette opération 92, le calculateur 22 acquiert N mesures $H_{mi}$ de l'intensité du champ $H_m$.

Ensuite, lors d'une opération 94, pour un bloc $B_i$, le calculateur compare la mesure $H_{mi}$ avec les seuils $S_{hi}$ et $S_{bi}$ de ce bloc $B_i$. Si la mesure $H_{mi}$ n'appartient pas à la plage $[S_{bi}; S_{hi}]$, alors le calculateur procède à une opération 96. Lors de l'opération 96 le bloc $B_i$ n'est pas sélectionné puis l'on retourne à l'opération 94 pour tester la mesure $H_{mi}$ d'un autre bloc.

Dans le cas contraire, lors d'une opération 98, le bloc $B_i$ est sélectionné.

Ensuite, lors d'une étape 100, la mesure de l'intensité du champ $H_m$ est établie par le calculateur 22 en utilisant uniquement la mesure du bloc $B_i$ sélectionné lors de l'étape 90.

Lors d'une étape 102, le calculateur 22 établit également la mesure de l'intensité du courant $I_m$ à partir de la mesure de l'intensité du champ $H_m$ établie lors de l'étape 100.

De nombreux autres modes de réalisation sont possibles. Par exemple, le nombre d'aimants utilisés pour former le générateur de champ magnétique peut être différent. Par exemple, dans un cas simplifié, un seul aimant est utilisé dans chaque bloc $B_i$. A l'inverse, plus de deux aimants peuvent être utilisés pour chaque bloc $B_i$. Dans un autre mode de réalisation simplifié, un seul aimant commun à tous les blocs $B_i$ est utilisé. Dans ce cas, cette unique aimant est associé à des guides de flux magnétiques permettant de guider le flux magnétique qu'il génère au niveau de chaque bloc $B_i$. De plus, ce guide de flux magnétiques est agencé de manière à ce que l'aimant délivre au niveau de chaque bloc $B_i$, le champ magnétique $CM_i$ ayant la bonne intensité. Les aimants peuvent être agencés au niveau de chaque barreau magnétorésistif ou au contraire être communs à un ensemble des barreaux magnétorésistifs d'un même pont de Wheatstone.

Le générateur de champ magnétique peut également comporter des moyens pour générer un champ magnétique dans chaque bloc $B_i$ parallèle à la direction de plus facile aimantation de la couche libre des barreaux magnétiques. Ceci permet de décroître l'hystérésis des barreaux magnétiques. Par exemple, pour cela, chaque aimant $AP_i$ est remplacé par un aimant dont la direction d'aimantation est inclinée d'un angle $\alpha$ compris entre $]0° ; 90°[$ par rapport à la direction Y.

Les transducteurs magnétorésistifs peuvent être réalisés de différentes façons. Par exemple, le transducteur magnétorésistif est réalisé à partir d'un seul barreau magnétorésistif. Dans ce cas, aucun pont de Wheastone n'est utilisé.

Dans un autre mode de réalisation, une autre configuration du pont de Wheatstone que celle précédemment décrite est utilisée. Par exemple, on pourra se référer à ce sujet aux différents ponts de Wheatstone décrits dans la demande US 2011/0227560.

Les barreaux magnétorésistifs utilisés dans chaque transducteur magnétorésistif ne sont pas nécessairement les mêmes que ceux utilisés dans les autres transducteurs magnétorésistifs. Ainsi, la plage $[a_i ; b_i]$ dans laquelle la réponse du transducteur $TM_i$ est linéaire à plus ou moins $x_i$% près n'est pas nécessairement la même que la plage $[a_j, b_j]$ dans laquelle la réponse du transducteur $TM_j$ est linéaire à plus ou moins $x_j$% près, $x_i$ et $x_j$ étant égaux. De même, les seuils $S_{hi}$ et $S_{bi}$ ne sont pas nécessairement tous identiques d'un bloc $B_i$ à l'autre.

La linéarité du capteur de champ magnétique n'est pas nécessairement la même sur chaque plage de la gamme de mesures. Par exemple, sur la plage $[a_i; b_i]$, celle-ci peut être fixée à $x_i$% et la linéarité sur une autre plage $[a_j ; b_j]$ peut être fixée à $x_j$% près, où $x_i$ et $x_j$ sont des valeurs différentes.

D'autres modes de réalisation des barreaux magnétorésistifs sont possibles. Par exemple, le barreau magnétorésistif est agencé pour former une jonction tunnel magnétique utilisant l'effet tunnel plus connu sous l'acronyme de TMR (Tunnel Magnetoresistance). Dans une jonction tunnel, l'espaceur est en matériau non magnétique isolant. Par exemple, il peut s'agir d'un oxyde ou d'un nitrure d'aluminium. Par exemple, l'espaceur est réalisé en alumine $Al_2O_3$, en oxyde de manganèse MgO ou en titane de strontium ($SrTiO_3$) ou autres.

Le conducteur 4 peut également être conformé de différentes façons. Par exemple, il peut ne comporter qu'un seul brin au-dessus duquel est placé le capteur de courant 2.

L'estimation $H_{em}$ de l'intensité du champ $H_m$ peut être construite à partir de mesure d'un autre capteur de champ magnétique que les blocs $B_i$. Par exemple, le capteur de champ magnétique comporte alors un transducteur supplémentaire, typiquement peu précis mais avec une très large gamme de mesure, utilisé uniquement pour réaliser l'estimation $H_{em}$. Cet autre transducteur n'est pas nécessairement un transducteur magnétorésistif. Par exemple, il peut s'agir d'un transducteur à effet Hall.

Les modes de réalisation décrits dans la demande US 2011/0227560 et ceux décrits ici peuvent être combinés ensemble. Dans ce cas, une ligne de compensation dans laquelle circule le courant de compensation $I_d$ décrit dans la demande US 2011/0227560 est ajoutée dans chaque bloc $B_i$.

Etant donné qu'il peut exister des plages $[a_i ; b_i]$ et $[a_{i+1}; b_{i+1}]$ qui se chevauchent, l'estimation $H_{em}$ peut se trouver en même temps dans deux plages. Dans ce cas, le calculateur 22 peut sélectionner les deux blocs $B_i$ et $B_{i+1}$ pour établir la mesure de l'intensité du champ

$H_m$. Dans une autre variante, il n'est pas nécessaire que les plages $[a_i ; b_i]$ se chevauchent. Certaines de ces plages peuvent alors être disjointes les unes des autres et donc séparées les unes des autres par une plage dans laquelle la mesure n'est pas linéaire.

**Revendications**

1. Capteur de champ magnétique le long d'une direction de mesure, ce capteur comportant N transducteurs magnétorésistifs $TM_i$, la résistance de chaque transducteur $TM_i$ variant linéairement à $\pm x_i$% près en fonction de l'intensité du champ magnétique à mesurer dans une plage maximale $[a_i ; b_i]$ d'intensité du champ magnétique à mesurer et non linéairement en dehors de cette plage, l'indice i étant un identifiant du transducteur $TM_i$, **caractérisé en ce que** le capteur comporte :

   - un générateur générant N champs magnétiques $CM_i$ à l'aide d'au moins un aimant permanent ($AP_i$), chaque champ $CM_i$ présentant une intensité $I_i$ dans la direction de mesure, cette intensité $I_i$ étant constante et indépendante de l'intensité du champ magnétique à mesurer, chaque transducteur $TM_i$ étant placé à l'intérieur d'un champ magnétique $CM_i$ respectif, chaque transducteur $TM_i$ placé à l'intérieur du champ $CM_i$ formant un bloc ($B_i$) de mesure pour lequel la plage où la résistance du transducteur $TM_i$ de ce bloc varie linéairement à $\pm x_i$% près est décalée de $I_i$ et devient $[a_i + I_i, b_i + I_i]$, chaque intensité $I_i$ étant différente des autres de manière à obtenir N plages $[a_i + I_i, b_i + I_i]$ différentes, N étant un nombre entier supérieur ou égal à deux,
   - un calculateur (22) apte :

      • à sélectionner le ou les blocs appropriés de mesure pour lesquels l'intensité du champ magnétique à mesurer est comprise dans la plage $[a_i + I_i, b_i + I_i]$ de ce bloc, et
      • à établir la mesure de l'intensité du champ magnétique à partir de la mesure du ou des seuls blocs de mesure sélectionnés.

2. Capteur selon la revendication 1, dans lequel les intensités $I_i$ augmentent en fonction de l'indice i et le générateur est apte à générer N champs $CM_i$ tels que la relation suivante soit vérifiée quel que soit i : $a_{i+1} + I_{i+1} \leq b_i + I_i$.

3. Capteur selon l'une quelconque des revendications précédentes, dans lequel, quel que soit i, la valeur $x_i$ est inférieure à 20 % ou 10 % ou 5 %.

4. Capteur selon l'une quelconque des revendications précédentes, dans lequel chaque transducteur magnétorésistif comprend au moins un barreau magnétorésistif (30-33) comprenant un empilement (38) d'au moins :

- une première couche magnétique (40), dite « couche de référence », dont la direction d'aimantation est fixe et perpendiculaire à la direction longitudinale du barreau magnétique à plus ou moins 10° près,
- une second couche magnétique (44), dite « couche libre », dont l'axe de plus facile aimantation est parallèle à la direction longitudinale et dont l'aimantation peut tourner lorsqu'elle est soumise au champ magnétique à mesurer, et
- une couche non magnétique (42), dite « espaceur », interposée entre les deux couches précédentes pour former une jonction tunnel ou une vanne de spin.

**5.** Capteur de courant comportant :

- un conducteur électrique (4) s'étendant le long d'une direction X et dans laquelle circule le courant à mesurer,
- un capteur (16 ; 112) de champ magnétique fixé sans aucun degré de liberté à ce conducteur électrique pour mesurer le champ magnétique généré par le courant à mesurer lorsqu'il circule dans ce conducteur électrique,
- un calculateur (22) programmé pour établir la mesure de l'intensité du courant à mesurer à partir de la mesure de l'intensité du champ magnétique mesurée par le capteur de champ magnétique, et

**caractérisé en ce que** le capteur de champ magnétique est conforme à l'une quelconque des revendications précédentes.

**6.** Procédé de mesure d'un champ magnétique le long d'une direction de mesure, ce procédé comportant la fourniture de N transducteurs magnétorésistifs $TM_i$, la résistance de chaque transducteur $TM_i$ variant linéairement à $\pm x_i\%$ près en fonction de l'intensité du champ magnétique à mesurer dans une plage maximale $[a_i ; b_i]$ d'intensité du champ magnétique à mesurer et non linéairement en dehors de cette plage, l'indice i étant un identifiant du transducteur $TM_i$,
**caractérisé en ce que** le procédé comporte :

- la génération de N champs magnétiques $CM_i$ à l'aide d'au moins un aimant permanent ($AP_i$), chaque champ $CM_i$ présentant une intensité $I_i$ dans la direction de mesure, cette intensité $I_i$ étant constante et indépendante de l'intensité du champ magnétique à mesurer, chaque transducteur $TM_i$ étant placé à l'intérieur d'un champ $CM_i$ respectif, chaque transducteur $TM_i$ placé à l'intérieur du champ $CM_i$ formant un bloc de mesure pour lequel la plage où la résistance du transducteur $TM_i$ de ce bloc varie linéairement à $\pm x_i\%$ près est décalée de $I_i$ et devient $[a_i + I_i, b_i + I_i]$, chaque intensité $I_i$ étant différente des autres de manière à obtenir N plages $[a_i + I_i, b_i + I_i]$ différentes, N étant un nombre entier supérieur ou égal à deux,

- la sélection (70 ; 90) du ou des blocs appropriés de mesure pour lesquels l'intensité du champ magnétique à mesurer est comprise dans la plage $[a_i + I_i, b_i + I_i]$ de ce bloc, et
- l'établissement (78 ; 100) de la mesure de l'intensité du champ magnétique à partir de la mesure du ou des seuls blocs de mesure sélectionnés.

**7.** Procédé selon la revendication 6, dans lequel le procédé comporte :

- la construction (74) d'une estimation $H_{em}$ de l'intensité du champ magnétique à mesurer, puis,
- la sélection (76) du ou des blocs appropriés de mesure en fonction de cette estimation $H_{em}$.

**8.** Procédé selon la revendication 6, dans lequel le procédé comporte :

- l'acquisition (92) de la mesure du champ magnétique réalisées par un bloc de mesure, et
- la sélection (98) de ce bloc de mesure en tant que bloc approprié de mesure uniquement si la mesure réalisée par ce bloc est comprise entre des seuils haut et bas prédéterminés.

**9.** Support (24) d'enregistrement d'informations, **caractérisé en ce qu'**il comporte des instructions pour la mise en oeuvre d'un procédé conforme à l'une quelconque des revendications 6 à 8, lorsque ces instructions sont exécutées par un calculateur électronique.

**Patentansprüche**

**1.** Sensor für Magnetfeld längs einer Messrichtung, wobei dieser Sensor N magnetoresistive Wandler $TM_i$ umfasst, wobei sich der Widerstand jedes Wandlers $TM_i$ als Funktion der Stärke des zu messenden Magnetfeldes in einem maximalen Bereich $[a_i; b_i]$ der Stärke des zu messenden Magnetfeldes linear bis auf $\pm x_i\%$ verändert und sich außerhalb dieses Bereichs nichtlinear verändert, wobei der Index i eine Kennung des Wandlers $TM_i$ ist, **dadurch gekennzeichnet, dass** der Sensor Folgendes umfasst:

- einen Generator, der mit Hilfe eines Permanentmagneten ($AP_i$) N Magentfelder $CM_i$ erzeugt, wobei jedes Feld $CM_i$ in der Messrichtung eine Stärke $I_i$ aufweist, wobei diese Stärke $I_i$ konstant und unabhängig von der Stärke des zu messenden Magnetfeldes ist, wobei jeder Wandler $TM_i$ innerhalb eines entsprechenden Magnetfeldes $CM_i$ angeordnet ist, wobei jeder Wandler $TM_i$, der innerhalb des Feldes $CM_i$ angeordnet ist, einen Messblock ($B_i$) bildet, für den der Bereich, in dem sich der Widerstand des Wandlers $TM_i$ dieses Blocks linear bis auf $\pm x_i$% verändert, um $I_i$ versetzt ist und $[a_i + I_i; b_i + I_i]$ wird, wobei jede Stärke $I_i$ von den anderen Stärken verschieden ist, derart, dass N unterschiedliche Bereiche $[a_i + I_i; b_i + I_i]$ erhalten werden, wobei N eine ganze Zahl gleich oder größer als zwei ist,

- einen Rechner (22), der zu Folgendem in der Lage ist:

• Wählen des oder der geeigneten Messblöcke, für die die Stärke des zu messenden Magnetfeldes in dem Bereich $[a_i + I_i; b_i + I_i]$ dieses Blocks liegt, und
• Erstellen der Messung der Stärke des Magnetfeldes anhand der Messung des oder der einzelnen gewählten Messblöcke.

2. Sensor nach Anspruch 1, wobei die Stärken $I_i$ als Funktion des Indexes i zunehmen und der Generator N Felder $CM_i$ erzeugen kann, derart, das die folgende Beziehung unabhängig von i erfüllt ist: $a_{i+1} + I_{i+1} \leq b_i + I_i$.

3. Sensor nach einem der vorhergehenden Ansprüche, wobei der Wert $x_i$ unabhängig von i kleiner als 20 % oder 10 % oder 5 % ist.

4. Sensor nach einem der vorhergehenden Ansprüche, wobei jeder magnetoresistive Wandler wenigstens einen magnetoresistiven Stab (30-33) umfasst, der einen Stapel (38) wenigstens aus Folgendem enthält:

- eine erste magnetische Schicht (40), die "Referenzschicht" genannt wird, deren Magnetisierungsrichtung fest und zu der Längsrichtung des magnetischen Stabs bis auf mehr oder weniger als 10° senkrecht ist,
- eine zweite magnetische Schicht (44), die "freie Schicht" genannt wird und deren Achse der schwächeren Magnetisierung zu der Längsrichtung parallel ist und deren Magnetisierung sich drehen kann, wenn sie dem zu messenden Magnetfeld unterworfen ist, und
- eine nicht magnetische Schicht (42), die "Abstandshalter" genannt wird und zwischen die zwei vorhergehenden Schichten eingefügt ist, um einen Tunnelübergang oder ein Spin-Ventil zu bilden.

5. Stromsensor, der Folgendes umfasst:

- einen elektrischen Leiter (4), der sich längs einer X-Richtung erstreckt und in der der zu messende Strom fließt,
- einen Magnetfeldsensor (16; 112), der ohne Freiheitsgrad an diesem elektrischen Leiter befestigt ist, um das Magnetfeld zu messen, das durch den zu messenden Strom erzeugt wird, wenn er in diesem elektrischen Leiter fließt,
- einen Rechner (22), der programmiert ist, die Messung der Stärke des zu messenden Stroms anhand der Messung der durch den Magnetfeldsensor gemessenen Stärke des Magnetfeldes zu bilden, und

**dadurch gekennzeichnet, dass** der Magnetfeldsensor wie in einem der vorhergehenden Ansprüche angegeben beschaffen ist.

6. Verfahren zum Messen eines Magnetfeldes längs einer Messrichtung, wobei dieses Verfahren das Bereitstellen von N magnetoresistiven Wandlern $TM_i$ umfasst, wobei sich der Widerstand jedes Wandlers $TM_i$ als Funktion der Stärke des zu messenden Magnetfeldes in einem maximalen Bereich $[a_i; b_i]$ der Stärke des zu messenden Magnetfeldes linear bis auf $\pm x_i$% und außerhalb dieses Bereichs nichtlinear verändert, wobei der Index i eine Kennung des Wandlers $TM_i$ ist,
**dadurch gekennzeichnet, dass** das Verfahren Folgendes umfasst:

- Erzeugen von N Magnetfeldern $CM_i$ mit Hilfe wenigstens eines Permanentmagneten ($AP_i$), wobei jedes Feld $CM_i$ in der Messrichtung eine Stärke $I_i$ aufweist, wobei diese Stärke $I_i$ konstant und unabhängig von der Stärke des zu messenden Magnetfeldes ist, wobei jeder Wandler $TM_i$ innerhalb eines jeweiligen Feldes $CM_i$ angeordnet ist, wobei jeder Wandler $TM_i$, der innerhalb des Feldes $CM_i$ angeordnet ist, einen Messblock bildet, für den der Bereich, in dem sich der Widerstand des Wandlers $TM_i$ dieses Blocks linear bis auf $\pm x_i$% verändert, um $I_i$ versetzt ist und $[a_i + I_i; b_i + I_i]$ wird, wobei jede Stärke $I_i$ von den anderen Stärken verschieden ist, derart, dass N verschiedene Bereiche $[a_i + I_i; b_i + I_i]$ erhalten werden, wobei N eine ganze Zahl größer oder gleich zwei ist,
- Auswählen (70; 90) des oder der geeigneten Messblöcke, für die die Stärke des zu messenden Magnetfeldes in dem Bereich $[a_i + I_i; b_i + I_i]$ dieses Blocks liegt, und

- Bilden (78; 100) der Messung der Stärke des Magnetfeldes anhand der Messung des oder der einzigen gewählten Messblöcke.

7. Verfahren nach Anspruch 6, wobei das Verfahren Folgendes umfasst:

    - Konstruieren (74) einer Schätzung $H_{em}$ der Stärke des zu messenden Magnetfeldes, dann
    - Auswählen (76) des oder der geeigneten Messblöcke als Funktion dieser Schätzung $H_{em}$.

8. Verfahren nach Anspruch 6, wobei das Verfahren Folgendes umfasst:

    - Erfassen (92) der Messung des Magnetfeldes, die durch einen Messblock verwirklicht wird, und
    - Auswählen (98) dieses Messblocks als geeigneten Messblock ausschließlich dann, wenn die durch diesen Block verwirklichte Messung zwischen einem vorgegebenen oberen und einem vorgegebenen unteren Schwellenwert enthalten ist.

9. Datenaufzeichnungsträger (24), **dadurch gekennzeichnet dass** er Befehle für die Ausführung eines Verfahrens nach einem der Ansprüche 6 bis 8, wenn diese Befehle von einem elektronischen Rechner ausgeführt werden, enthält.


**Claims**

1. Sensor of magnetic fields along a direction of measurement, this sensor comprising N magneto-resistive transducers $TM_i$, the resistance of each transducer $TM_i$ varying linearly to within $\pm x_i$ % as a function of the intensity of the magnetic field to be measured within a maximum range $[a_i ; b_i]$ of intensity of the magnetic field to be measured and non-linearly outside of this range, the index i being an identifier of the transducer $TM_i$,
**characterized in that** the sensor comprises:

    - a generator generating N magnetic fields $CM_i$ using at least one permanent magnet ($AP_i$), each field $CM_i$ exhibiting an intensity $I_i$ in the direction of measurement, this intensity $I_i$ being constant and independent of the intensity of the magnetic field to be measured, each transducer $TM_i$ being placed inside a respective magnetic field $CM_i$, each transducer $TM_i$ placed inside the field $CM_i$ forming a measurement block ($B_i$) for which the range in which the resistance of the transducer $TM_i$ of this block varies linearly to within $\pm x_i$ % is offset by $I_i$ and becomes $[a_i + I_i; b_i + I_i]$, each intensity $I_i$ being different from the others so as to obtain N different ranges $[a_i + I_i;$

$b_i + I_i]$, N being an integer number greater than or equal to two,
    - a computer (22) capable:

        • of selecting the appropriate measurement block or blocks for which the intensity of the magnetic field to be measured lies within the range $[a_i + I_i; b_i + I_i]$ of this block, and
        • of establishing the measurement of the intensity of the magnetic field on the basis of the measurement of the only measurement block or blocks selected.

2. Sensor according to Claim 1, wherein the intensities $I_i$ increase as a function of the index i and the generator is capable of generating N fields $CM_i$ such that the following relationship is borne out regardless of i: $a_{i+1} + I_{i+1} \leq b_i + I_i$.

3. Sensor according to any one of the preceding claims, wherein, regardless of i, the value $x_i$ is less than 20 % or 10 % or 5 %.

4. Sensor according to any one of the preceding claims, wherein each magnetoresistive transducer comprises at least one magneto-resistive bar (30-33) comprising a stack (38) of at least:

    - a first magnetic layer (40), called "reference layer" whose direction of magnetization is fixed and at right angles to the longitudinal direction of the magnetic bar to within plus or minus 10°,
    - a second magnetic layer (44), called "free layer", for which the axis of easiest magnetization is parallel to the longitudinal direction and for which the magnetization can rotate when it is subjected to the magnetic field to be measured, and
    - a non-magnetic layer (42), called "spacer", interposed between the two preceding layers to form a tunnel junction or a spin valve.

5. Current sensor comprising:

    - an electrical conductor (4) extending along a direction X and in which the current to be measured circulates,
    - a magnetic field sensor (16; 112) fixed with no degree of freedom to this electrical conductor to measure the magnetic field generated by the current to be measured when it circulates in this electrical conductor,
    - a computer (22) programmed to establish the measurement of the intensity of the current to be measured on the basis of the measurement of the intensity of the magnetic field measured by the magnetic field sensor, and

**characterized in that** the magnetic field sensor conforms to any one of the preceding claims.

6. Method for measuring a magnetic field along a direction of measurement, this method comprising the supply of N magneto-resistive transducers $TM_i$, the resistance of each transducer $TM_i$ varying linearly to within $\pm x_i$ % as a function of the intensity of the magnetic field to be measured within a maximum range $[a_i; b_i]$ of intensity of the magnetic field to be measured and non-linearly outside of this range, the index i being an identifier of the transducer $TM_i$, **characterized in that** the method comprises:

- the generation of N magnetic fields $CM_i$ using at least one permanent magnet ($AP_i$), each field $CM_i$ exhibiting an intensity $I_i$ in the direction of measurement, this intensity $I_i$ being constant and independent of the intensity of the magnetic field to be measured, each transducer $TM_i$ being placed inside a respective field $CM_i$, each transducer $TM_i$ placed inside the field $CM_i$ forming a measurement block for which the range in which the resistance of the transducer $TM_i$ of this block varies linearly to within $\pm x_i$ % is offset by $I_i$ and becomes $[a_i + I_i; b_i + I_i]$, each intensity $I_i$ being different from the others so as to obtain N different ranges $[a_i + I_i; b_i + I_i]$, N being an integer number greater than or equal to two,
- the selection (70; 90) of the appropriate measurement block or blocks for which the intensity of the magnetic field to be measured lies within the range $[a_i + I_i; b_i + I_i]$ of this block, and
- the establishment (78; 100) of the measurement of the intensity of the magnetic field on the basis of the measurement of the only measurement block or blocks selected.

7. Method according to Claim 6, wherein the method comprises:

- the construction (74) of an estimation $H_{em}$ of the intensity of the magnetic field to be measured, then,
- the selection (76) of the appropriate measurement block or blocks as a function of this estimation $H_{em}$.

8. Method according to Claim 6, wherein the method comprises:

- the acquisition (92) of the measurement of the magnetic field produced by a measurement block, and
- the selection (98) of this measurement block as appropriate measurement block only if the measurement produced by this block lies between predetermined high and low thresholds.

9. Information storage medium (24), **characterized in that** it comprises instructions for implementing a method conforming to any one of Claims 6 to 8, when these instructions are executed by an electronic computer.

Fig. 1

Fig. 2

Fig. 3

## Fig. 4

## Fig. 5

## Fig. 6

**EP 2 802 886 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20110227560 A
- WO 2007148028 A
- US 2006291106 A1